# EUROPÄISCHE PATENTANMELDUNG

(11) **EP 3 958 462 A1**
(43) Veröffentlichungstag der Anmeldung: **23.02.2022**
(21) Anmeldenummer: 21196742.7
(22) Anmeldetag: 26.10.2017
(51) Int. Cl.: H03F 3/217, H02M 3/139, H03F 3/30, H04M 3/40, H04B 3/54, H04B 14/02, H04L 12/10, H02M 3/335

(54) **VERSTÄRKERSCHALTUNG UND VERFAHREN ZUM BETRIEB EINER VERSTÄRKERSCHALTUNG**

(30) Priorität: 14.11.2016 EP 16198640
(62) Teilanmeldung aus: 17798123.0
(71) Anmelder: Siemens Schweiz AG, 8047 Zürich (CH)
(72) Erfinder: Waldmeier, Christoph, 8854 Siebenen (CH)
(74) Vertreter: Maier, Daniel Oliver

(57) **Zusammenfassung**

Die Erfindung ist eine als Linientreiber fungierende Verstärkerschaltung (2a) und ein Verfahren zu deren Betrieb, wobei in die Verstärkerschaltung (2a) als Leistungsstufe ein DC/DC-Wandler (1) integriert ist.

## Beschreibung

Die Erfindung betrifft eine Verstärkerschaltung sowie ein Verfahren zum Betrieb einer Verstärkerschaltung.

Verstärkerschaltungen und Verfahren zur deren Betrieb sind an sich bekannt.

Aus der US 2013/0258731 A1 ist eine digitale Stromversorgung bekannt, die eine Spannungsregelschleife und eine Stromregelschleife umfasst. Die Stromversorgung weist einen Regler zur Pulsweitenmodulation eines Schaltnetzteils gemäß einem Spannungsregelschleifen-Tastverhältnisausgang oder einem Stromregelschleifen-Tastverhältnisausgang auf, wobei der Regler selektiv den Spannungsregelkreis-Tastverhältnisausgang auf einen vorbestimmten Wert voreinstellt, bevor der Regler von der Stromregelschleife auf die Spannungsregelschleife umschaltet und/oder den Anstieg eines Spannungsregelschleifen-Integratorwerts während der Stromregelschleife verhindert, um ein Überschwingen der Spannung zu vermindern.

Aus der US 2014/0313784 A1 ist eine Verstärkerschaltung bekannt, welche einen Gleichspannungswandler und zwei galvanisch getrennte Schaltstufen umfasst. Schalter der beiden Schaltstufen sind mittels eines einen PWM-Modulator umfassenden Logikblocks ansteuerbar.

Nachteilig bei bekannten Verstärkerschaltungen sind zum Beispiel ungünstige Verlustleistungen und nicht immer exakte Verstärkungsverhältnisse.

Brandmelder und andere in einem Netzwerk zusammengefasste adressierte Notifikationsgeräte wie zum Beispiel Rauchdetektoren, Meldegeräte, Alarmierungsgeräte wie Blitzleuchten und sogenannte Sounder (Hörner), Ein-/Ausgabegeräte (I/O-Devices), Repeater, Terminals, Stockwerkanzeigen und dergleichen - im Folgenden einzeln und zusammen kurz als Feldgerät bzw. Feldgeräte bezeichnet - werden über eine Melderlinie mit einem Kommunikationsprotokoll, üblicherweise dem sogenannten FDnet-Protokoll, betrieben und über die Melderlinie und im Rahmen des Kommunikationsprotokolls mit elektrischer Energie versorgt. Das Kommunikationsprotokoll sieht einen hohen Spannungshub vor. Üblicherweise ist eine solche Melderlinie galvanisch von einem restlichen Brandmeldesystem getrennt. Der Trend, immer mehr Feldgeräte, wie adressierte sogenannte Loopsounder und Blitzleuchten, zu installieren, führt zu einem erhöhten Strombedarf auf den Meldelinien des Netzwerks.

Der Treiber der Linie soll den benötigten Strom zu den Feldgeräten liefern. Die Steigerung der installierten Leistung auf der Linie verlangt nach stärkeren Linientreibern. Der gesteigerte Leistungsbedarf verursacht mit der bestehenden Lösung erhöhte Verlustleistung sowie Probleme mit der Strombegrenzung.

In der älteren, nicht vorveröffentlichen europäischen Patentanmeldung 15 170 028.3 mit dem Titel "Verstärkerschaltung und Verfahren zum Betrieb einer Verstärkerschaltung" (Anmeldetag: 01.06.2015) ist eine Verstärkerschaltung und ein Verfahren zu deren Betrieb beschrieben, wobei die Verstärkerschaltung einen beidseitig galvanisch isolierten und als Verstärker fungierenden Gleichspannungswandler umfasst, wobei ein Ausgangssignal der Verstärkerschaltung mittels eines Rückführzweigs auf einen eingangsseitigen Summationspunkt zurückgeführt ist und wobei der Gleichspannungswandler zwischen den Summationspunkt und einen ausgangsseitigen Ausgangsfilter geschaltet ist. Die bei einem getrennten Aufbau des Spannungsversorgungsteils und des Verstärkungsteils redundanten Schaltungsteile, nämlich der Pulsweitenmodulator, die erste und die zweite Schaltstufe und der Ausgangsfilter des DC/DC-Konverters, werden zur Verstärkung des Eingangssignals und zur direkten Erzeugung des Ausgangssignals genutzt.

Eine Aufgabe der vorliegenden Erfindung besteht darin, eine demgegenüber noch weiter verbesserte Verstärkerschaltung und ein Verfahren zu deren Betrieb anzugeben.

Diese Aufgabe wird erfindungsgemäß mittels einer als Linientreiber fungierenden Verstärkerschaltung mit den Merkmalen des Anspruchs 1 gelöst. Die Verstärkerschaltung umfasst einen DC/DC-Wandler, der als Leistungsstufe in die Verstärkerschaltung integriert ist. Mittels des DC/DC-Wandlers und dessen Integration in die Verstärkerschaltung wird eine galvanische Trennung der eingangsseitigen Versorgungsspannung Vᵢₙ von der mittels der Verstärkerschaltung erzeugten Ausgangsspannung Vₒᵤₜ in einer Weise erreicht, dass die gewünschte Ausgangsspannung Vₒᵤₜ und das gewünschte Ausgangssignal direkt und ohne das Erzeugen einer DC-Zwischenspannung entstehen.

Der Vorteil dieses Aspekts der Erfindung besteht vor allem in der vereinfachten Ausführung der ersten Schaltstufe des Spannungswandlers. Bei der Schaltung gemäß der älteren Anmeldung umfasst die erste Schaltstufe eingangs- und ausgangsseitige induktive Übertrager sowie zwei gegenläufig angesteuerte Brücken. Bei der hier vorgeschlagenen Schaltung tritt an die Stelle einer solchen Leistungsstufe eine deutlich einfachere Leistungsstufe. Mittels der Leistungsstufe wird die Eingangsspannung Vᵢₙ in einer Art und Weise zerhackt, dass gerade die gewünschte Ausgangsspannung entsteht und zwar mittels eines pulsweitenmodulierten Signals (PWM-Signal), dessen Tastverhältnis (Einschaltzeit/Periodendauer) gleich der gewünschten Ausgangsspannung im Verhältnis zur mit der Transformerübersetzung multiplizierten Eingangsspannung Vᵢₙ ist.

Des Weiteren ist vorgesehen, dass der in die Verstärkerschaltung integrierte DC/DC-Wandler als DC/Puls-Wandler fungiert und zwei galvanisch getrennte Schaltstufen umfasst. Mittels eines dem DC/Puls-Wandler vorgeschalteten Logikblocks sind aus einem PWM-Signal Ansteuersignale für Schalter des DC/Puls-Wandlers generierbar und mittels Treibern galvanisch isoliert in den DC/Puls-Wandler einspeisbar.

Schließlich umfasst die Verstärkerschaltung einen Prioritätsblock sowie einen ersten Regler und einen zweiten Regler und das oben genannte PWM-Signal ist anhand eines Ausgangs des Prioritätsblocks generierbar. Dafür ist mittels des Prioritätsblocks entweder ein Ausgangssignal des ersten Reglers oder ein Ausgangssignal des zweiten Reglers weiterleitbar. Mittels des ersten Reglers ist ein erstes Fehlersignal auf Basis eines vorgegebenen oder vorgebbaren Spannungsgrenzwerts sowie einer innerhalb der Verstärkerschaltung über einen Rückführzweig zurückgeführten Ausgangsspannung generierbar. Mittels des zweiten Reglers ist ein zweites Fehlersignal auf Basis eines vorgegebenen oder vorgebbaren Stromgrenzwerts sowie eines innerhalb der Verstärkerschaltung über einen Rückführzweig zurückgeführten Ausgangsstroms generierbar. In Form der beiden Regler umfasst die Verstärkerschaltung je einen Regelkreis für Strom und Spannung, welche ein primärseitiges Stellglied (erste Schaltstufe) galvanisch getrennt ansteuern.

Dieses Stellglied zerhackt (PWM) die Eingangsspannung Vᵢₙ und führt sie über einen gesteuerten Gleichrichter auf ein Filter, welches die Schaltfrequenz herausfiltert.

Vorteilhafte Ausgestaltungen der Erfindung sind Gegenstand der Unteransprüche. Dabei verwendete Rückbeziehungen weisen auf die weitere Ausbildung des Gegenstandes des Hauptanspruches durch die Merkmale des jeweiligen Unteranspruches hin. Sie sind nicht als ein Verzicht auf die Erzielung eines selbständigen, gegenständlichen Schutzes für die Merkmalskombinationen der rückbezogenen Unteransprüche zu verstehen. Des Weiteren ist im Hinblick auf eine Auslegung der Ansprüche bei einer näheren Konkretisierung eines Merkmals in einem nachgeordneten Anspruch davon auszugehen, dass eine derartige Beschränkung in den jeweils vorangehenden Ansprüchen nicht vorhanden ist. Jede Bezugnahme in der Beschreibung auf Aspekte nachgeordneter Ansprüche ist demnach auch ohne speziellen Hinweis ausdrücklich als Beschreibung optionaler Merkmale zu lesen.

Mit der durch das Einbinden von Blitzleuchten nötigen Steigerung der Ausgangsleistung wird eine analoge (lineare) Lösung zunehmend schwierig, ineffizient und kosten- und platzaufwendiger. Bei der linearen Lösung geht immer ein gewisser Teil der Leistung im linearen Treiber verloren. Zusammen mit den Verlusten des vorgeschalteten DC/DC-Wandlers beträgt die Verlustleistung 30-40%.Bei einer Ausgangsleistung von etwa 50W sind dies fast 20W. Eine solche Verlustleistung ist nicht mehr mit einer einfachen, kostengünstigen Kühlung handhabbar. Im Falle eines Fehlers muss sogar für eine gewisse Zeit die gesamte Ausgangsleistung als Verlustleistung abgeführt werden, was große Probleme schafft. Eine geschaltete Lösung kann die Ausgangsspannung (Feldgerätespannung, Melderspannung) mit hoher Effizienz erzeugen, wobei im Fehlerfall die Energie nicht als Verlustleistung verbraucht, sondern gar nicht erst bezogen wird.

Ausgehend von dem Umstand, dass bereits bisher ein DC/DC-Wandler zur Stabilisierung und galvanischen Trennung der DC-Eingangsspannung eines linearen Verstärkers verwendet wird, besteht ein zentraler Aspekt der hier vorgeschlagenen Neuerung darin, den Wandler und den Verstärker zu einer einzigen geschalteten Stufe zusammenzufassen.

Eine Leiterplatte mit der hier vorgeschlagenen Schaltung erhöht die Effizienz eines Melderlinien-Treibers von 65% auf fast 90%. Trotz der aufwendigeren Schaltung ist die Schaltung mit einem Ausgangsstrom von 1,5 A nur wenig teurer als die bestehende lineare Lösung mit 0,5 A Ausgangsstrom. Der Platzbedarf konnte gegenüber der bestehenden Lösung um ca. 30% reduziert werden. Weil bei der hier vorgeschlagenen Schaltung die Strombegrenzung nun verlustfrei ist, ist auch das Verhalten bei Fehlerfällen deutlich verbessert. Durch die Möglichkeit der Verwendung unterschiedlicher Schalttopologien ist die Lösung leistungsmäßig sehr gut skalierbar.

Bei einem Verfahren zum Betrieb einer solchen Verstärkerschaltung werden die übliche, galvanisch getrennte Erzeugung der Versorgungspannung des Verstärkers und der Verstärker selbst in einer Schaltung kombiniert.

Dabei gelten Merkmale und Details, die im Zusammenhang mit der Verstärkerschaltung und eventueller Ausgestaltungen beschrieben sind, selbstverständlich auch im Zusammenhang mit einem Verfahren und einzelner Ausgestaltungen eines solchen Verfahrens zum Betrieb einer Verstärkerschaltung und jeweils umgekehrt, so dass bezüglich der Offenbarung zu den einzelnen Aspekten der Erfindung stets wechselseitig Bezug genommen wird bzw. werden kann.

Für die weitere Beschreibung gilt zur Vermeidung unnötiger Wiederholungen, dass das Verfahren auch mittels einzelner oder mehrerer Verfahrensmerkmale fortgebildet sein kann, die sich auf von der Verstärkerschaltung und davon umfassten Mitteln ausgeführte Verfahrensschritte beziehen und die Verstärkerschaltung entsprechend mittels einzelner oder mehrerer Vorrichtungsmerkmale fortgebildet sein kann, die sich auf Mittel zur Ausführung von im Rahmen des Verfahrens ausgeführten Verfahrensschritten beziehen.

Insgesamt ist die Erfindung auch eine Vorrichtung zum Ansteuern von als Alarmierungs-Einrichtungen fungierenden Feldgeräten der eingangs genannten Art mit einer Verstärkerschaltung wie hier und im Folgenden beschrieben und/oder einer Verstärkerschaltung mit Mitteln zur Ausführung des Betriebsverfahrens.

Nachfolgend werden Ausführungsbeispiele der Erfindung anhand der Zeichnung näher erläutert. Einander entsprechende Gegenstände oder Elemente sind in allen Figuren mit den gleichen Bezugszeichen versehen.

Es zeigen
- FIG 1: eine bekannte Verstärkerschaltung mit einem vorgeschalteten DC/DC-Wandler zur Erzeugung der Versorgungsspannung des Verstärkers,
- FIG 2: weitere Einzelheiten der Schaltung gemäß FIG 1,
- FIG 3: eine Ausführungsform einer hier vorgeschlagenen Verstärkerschaltung,
- FIG 4: Einzelheiten der Schaltung gemäß FIG 3,
- FIG 5: Details zur Funktion eines von der Schaltung gemäß FIG 3, FIG 4 umfassten Logikblocks,
- FIG 6: eine symbolische Darstellung der Funktion des Logikblocks gemäß FIG 5 und
- FIG 7: einen zeitlichen Verlauf einzelner wesentlicher Signale beim Betrieb der hier vorgeschlagenen Verstärkerschaltung.

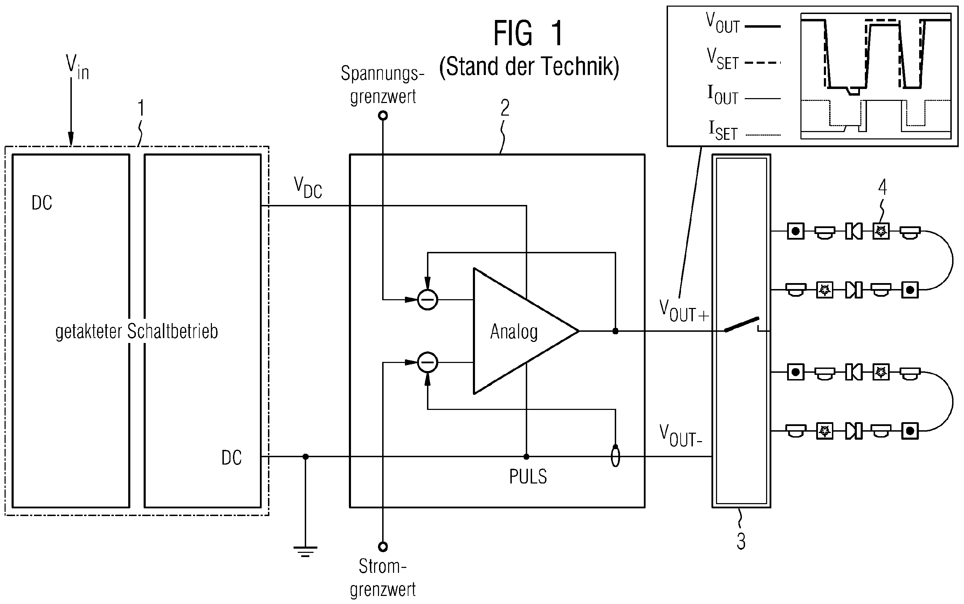

FIG 1 zeigt eine bekannte, als Lininentreiber (line driver) fungierende Verstärkerschaltung. Diese umfasst zur Erzeugung der Versorgungsspannung der Verstärkerschaltung eingangsseitig einen galvanisch isolierten DC/DC-Wandler 1 und einen nachgeschalteten Linearverstärker 2. An den Linearverstärker 2 ist eine Multiplexerschaltung 3 angeschlossen, welche die mittels des Linearverstärkers 2 erzeugte Ausgangsspannung Vₒᵤₜ₊, Vₒᵤₜ₋ geschaltet an einzelne Zweige eines Netzwerks mit Verbrauchern in Form von Feldgeräten 4, insbesondere Rauchdetektoren, Meldegeräte, Alarmierungsgeräte wie Blitzleuchten und Sounder (Hörner), Ein-/Ausgabegeräte (I/O-Devices) und Stockwerksanzeigen, weitergibt. Mittels der Multiplexerschaltung 3 sind zum Beispiel auch einzelne Zweige des Netzwerks abschaltbar, zum Beispiel Zweige mit einem Kurzschluss aufgrund eines defekten Feldgeräts 4.

Ein Linientreiber ist in grundsätzlich an sich bekannter Art und Weise zur Gewährleistung und/oder Verbesserung der Qualität der über die jeweilige Übertragungsleitung (Meldelinie) zu übertragenden elektrischen Signale bestimmt. Die hier vorgeschlagene Verstärkerschaltung ist als Linientreiber in einer zwischen einer nicht gezeigten Zentrale und den Feldgeräten 4 verlaufenden Übertragungsleitung vorgesehen. Die Zentrale erzeugt die über die Übertragungsleitung übermittelten Daten für die angeschlossenen Feldgeräte 4, zum Beispiel zu deren Ansteuerung, insbesondere zu einer Ansteuerung, welche ein jeweiliges Feldgerät 4 zur Ausgabe von Signalen oder zum Übermitteln von Feueralarmen sowie Statusmeldungen über die jeweilige Leitung und damit in dem Feldgerätenetzwerk veranlasst, die einen Messwert des Feldgeräts 4 oder dergleichen kodieren. Diese Daten werden von der Zentrale als Sollwerte an die Eingänge voltage set und current set ausgegeben.

Mittels des DC/DC-Wandlers 1 wird aus der Eingangsspannung Vᵢₙ galvanisch isoliert eine konstante Ausgangsspannung (Ausgangsgleichspannung) V_{DC} erzeugt. Für den DC/DC-Wandler kommen abhängig von einer jeweils gewünschten Ausgangsleistung unterschiedliche Topologien in Betracht, nämlich zum Beispiel eine sogenannte Flyback-Topologie (deutsch: Sperrwandler) oder eine sogenannte Forward-Topologie (deutsch: Flusswandler) .

Die Kommunikation mit den Feldgeräten 4 erfolgt nach einem vorgegebenen Protokoll, zum Beispiel dem FDnet-Protokoll. Dabei folgen in äquidistanten Übertragungszyklen jeweils eine Ladephase ohne Kommunikation und eine Kommunikationsphase aufeinander. Während der Ladephase erfolgt die Energieversorgung der angeschlossenen Feldgeräte 4. Während der Kommunikationsphase werden Informationen für die Feldgeräte 4 über das Netzwerk übertragen.

Mittels des Linearverstärkers 2 erfolgt eine Modulation der dem Linearverstärker 2 eingangsseitig zugeführten Ausgangsgleichspannung V_{DC} des DC/DC-Wandlers 1 und der Linearverstärker 2 begrenzt den Strom in der Übertragungsleitung während eines Übertragungszyklus. Die resultierende modulierte Spannung (Ausgangsspannung, Vₒᵤₜ) ermöglicht während der Kommunikationsphase eine Kommunikation mit den Feldgeräten 4, wobei die Daten bidirektional übertragen werden. Auch während der Kommunikationsphase werden die Feldgeräte 4 während der High-Pegel der Ausgangsspannung Vₒᵤₜ mittels der Ausgangsspannung Vₒᵤₜ mit elektrischer Energie versorgt.

Während einer Ladephase gilt ein oberer Grenzwert für den Strom und während der Low-Phase des Übertragungszyklus kann ein anderer Grenzwert gesetzt werden, wie dies in der Darstellung in FIG 1 oben rechts schematisch vereinfacht gezeigt ist. Die Grenzwerte Vₛₑₜ und Iₛₑₜ für die Begrenzung der Ausgangsspannung Vₒᵤₜ und des Stroms Iₒᵤₜ sind mittels zweier Eingänge des Linearverstärkers 2 (voltage set bzw. current set) vorgebbar und werden beim Betrieb dynamisch mittels dieser Eingänge vorgegeben.

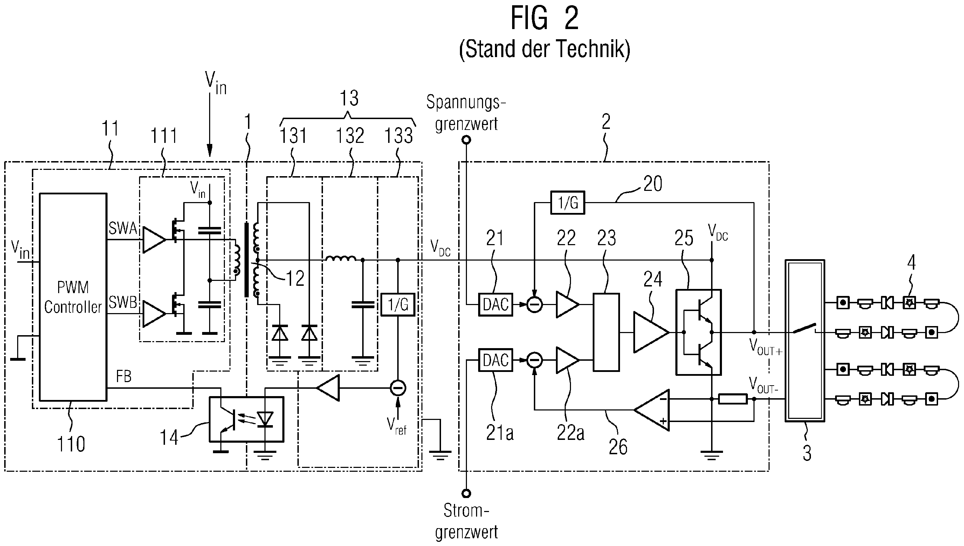

Die Darstellung in FIG 2 zeigt den Leitungsverstärker gemäß FIG 1 mit weiteren Details. Danach umfasst der DC/DC-Wandler 1 eine erste Schaltstufe 11 und eine zweite Schaltstufe 13. Die beiden Schaltstufen 11, 13 sind im Wege einer induktiven Kopplung mittels eines Transformators 12, insbesondere eines Leistungstransformators, einerseits sowie mittels eines Rückführzweigs 133 mit einem anschließenden Optokoppler 14 andererseits galvanisch voneinander getrennt.

Die erste Schaltstufe 11 umfasst einen Pulsweitenmodulator 110 und eine Leistungsstufe 111. Bei der gezeigten Ausführungsform fungiert eine Halbbrücke als Leistungsstufe 111. Andere Ausführungsformen einer Leistungsstufe 111 sind ebenfalls möglich, zum Beispiel alle bekannten Ausführungen von Flusswandlern oder Sperrwandlern in verschiedenen Ausführungen wie zum Beispiel Push-Pull oder Vollbrücke. In der ersten Leistungsstufe 111 wird das zu verstärkende und zu übertragende, üblicherweise batteriegepufferte Eingangssignal Vᵢₙ zugeführt.

Die zweite Schaltstufe 13 umfasst eine Gleichrichterschaltung 131, welche die über den Transformator 12 übertragene, entsprechend dem vom Pulsweitenmodulator 110 erzeugten PWM-Signal zerhackte Spannung gleichrichtet. Bei der gezeigten Ausführungsform fungiert eine Schaltung mit Dioden als Gleichrichterschaltung 131 (asynchrone Gleichrichtung). Eine Synchrongleichrichtung ist ebenfalls möglich, aber nicht notwendig.

Mittels eines Filters 132 (Ausgangsfilter), insbesondere eines als Tiefpassfilter fungierenden Filters 132 in Form eines LC-Glieds, erfolgt eine Filterung der zerhackten und gleichgerichteten Spannung zum Erhalt der Ausgangsspannung V_{DC}. Die Ausgangsspannung V_{DC} wird dem Pulsweitenmodulator 110 über den Rückführzweig 133 und den Optokoppler 14 zur geregelten Stabilisierung der Ausgangsspannung V_{DC} zugeführt.

Der Linearverstärker 2 moduliert die vom DC/DC-Wandler 1 erhaltene Ausgangsgleichspannung V_{DC} gemäß den über die Eingänge voltage set und current set vorgegebenen Werten für die maximale Spannung und den maximalen Strom. Dafür sind ein erster und ein zweiter D/A-Wandler 21, 21a (digital analog converter; DAC) vorgesehen.

Von dem aufgrund des über den Eingang voltage set vorgegebenen Spannungsgrenzwerts Vₛₑₜ resultierenden Wert am Ausgang des ersten D/A-Wandlers 21 wird die über einen Rückführzweig 20 mit inverser Systemverstärkung (1/G) zurückgeführte Ausgangsspannung Vₒᵤₜ₊ abgezogen und das resultierende Signal einem ersten Regler 22 zugeführt. Ähnlich wird von dem aufgrund des über den Eingang current set vorgegebenen Stromgrenzwerts Iₛₑₜ resultierenden Wert am Ausgang des zweiten D/A-Wandlers 21a der über einen Rückführzweig 26 zurückgeführte jeweilige Ausgangsstrom abgezogen und das resultierende Signal einem zweiten Regler 22a zugeführt.

Die Ausgangssignale beider Regler 22, 22a werden zunächst einem Prioritätsblock 23 zugeführt. Aufgrund des Prioritätsblocks 23 wird eines der Ausgangssignale der Regler 22, 22a am Ausgang des Prioritätsblocks 23 einem Vorverstärker 24 zugeführt. Mittels des Prioritätsblocks 23 wird für den Fall eines den Stromgrenzwert (Iₛₑₜ) überschreitenden Ausgangsstroms (Iₒᵤₜ) ein Vorrang (Priorität) des Stromgrenzwerts (I-ₛₑₜ) gegenüber dem Spannungsgrenzwert (Vₛₑₜ) realisiert. Je nachdem, ob die Spannung gehalten oder aufgrund eines Überstroms reduziert werden muss, arbeitet entweder die Spannungsregelung (erster Regler 22) oder die Stromregelung (zweiter Regler 22a). Bis zur Strombegrenzung wird die Ausgangsspannung gehalten, ist der Maximalstrom erreicht, wird sie reduziert und der Maximalstrom gehalten.

Mittels des Vorverstärkers 24 wird eine Leistungsstufe 25 angesteuert, welche als tatsächliches Ausgangssignal des Leitungsverstärkers die Ausgangsspannung Vₒᵤₜ₊ erzeugt. Diese wird über die Multiplexerschaltung 3 an die Feldgeräte 4 ausgegeben.

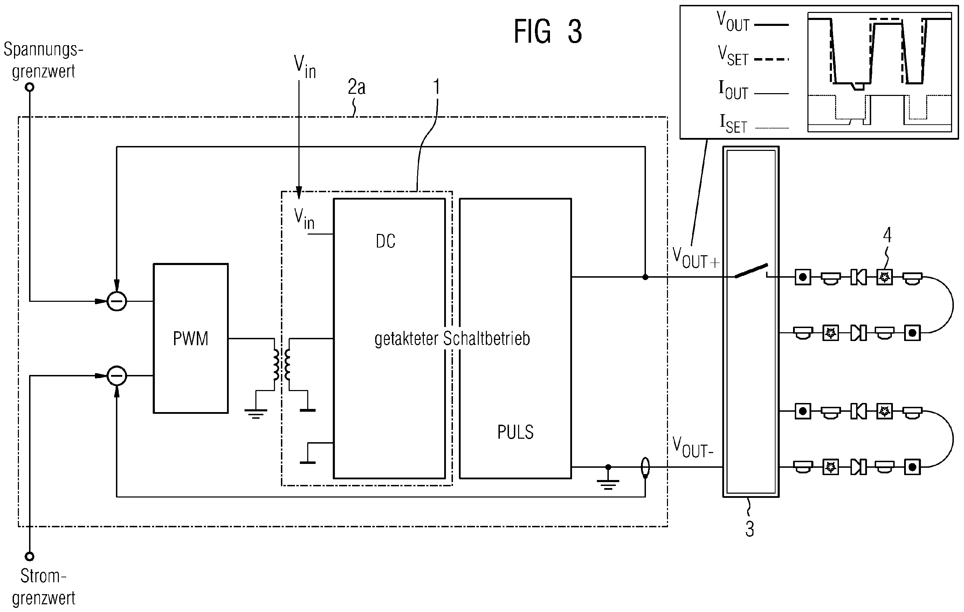

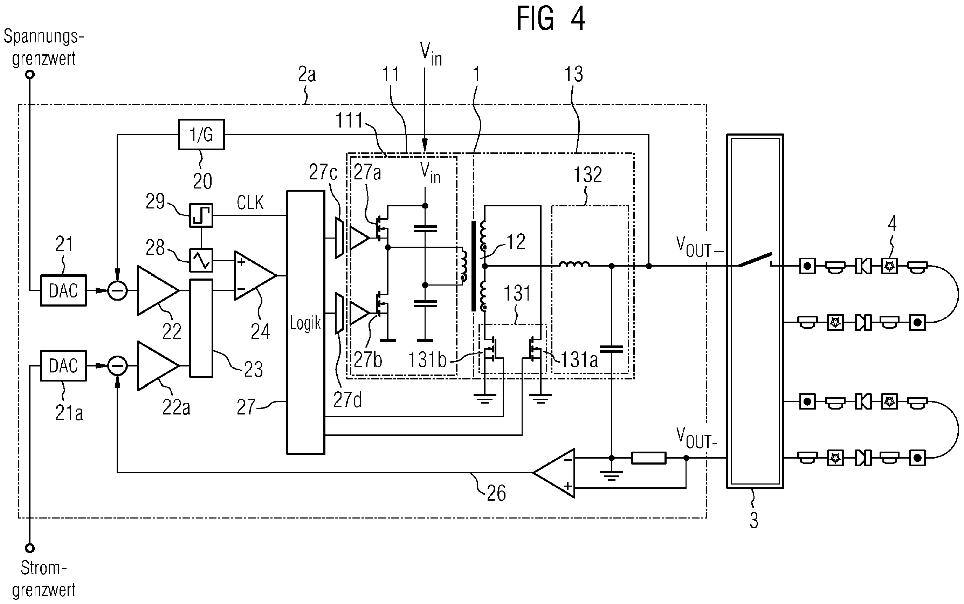

Die Darstellung in FIG 3 zeigt in der Form wie in FIG 1 eine schematisch vereinfachte Übersichtsdarstellung der hier vorgeschlagenen und als Linientreiber (line driver; switched mode line driver) fungierenden Verstärkerschaltung 2a. Diese umfasst - siehe auch FIG 1 und die zugehörige Beschreibung - einen DC/DC-Wandler 1 mit zwei galvanisch voneinander isolierten Schaltstufen 11, 13 (FIG 4), welcher als Endstufe in der Verstärkerschaltung 2a fungiert. Im Unterschied zur Situation gemäß FIG 1 und FIG 2 ist dem DC/DC-Wandler 1 kein Linearverstärker 2 nachgeschaltet. Vielmehr ist ein modifizierter DC/DC-Wandler 1 in die Verstärkerschaltung 2a integriert und ersetzt dort die analoge Leistungsstufe 25. Der modifizierte DC/DC-Wandler 1 generiert - anders als der DC/DC-Wandler 1 in FIG 1, FIG 2 - keine Ausgangsgleichspannung V_{DC}, sondern vielmehr Spannungspulse und wird deshalb im Folgenden zur Unterscheidung von der Ausführungsform gemäß FIG 1, FIG 2 als DC/Puls-Wandler 1 bezeichnet. Durch das Wegfallen des DC/DC-Wandlers wird nun das PWM-Signal nicht mehr mittels eines separaten Pulsweitenmodulators 110 (FIG 2), sondern unmittelbar mittels des Linientreibers 2a erzeugt, wobei das neue PWM-Signal der gewünschten Ausgangsspannung entspricht, während bei der Situation gemäß FIG 2 das dort mittels des separaten Pulsweitenmodulators 110 erzeugte PWM-Signal einer festen DC-Spannung entspricht. Das PWM-Signal muss über die mittels des DC/Puls-Wandlers 1 realisierte galvanische Trennung zwischen der Ein- und Ausgangsseite des Leitungsverstärkers übertragen werden. Dies erfolgt mittels eines Transformers oder einer Halbleiter-Schaltung (semiconductor isolator/driver). Die Anzahl der Leistungsstufen ist damit gegenüber der Schaltung gemäß FIG 2 um eine Leistungsstufe reduziert. Dies führt zu einer Kostenersparnis und zu einem reduzierten Platzbedarf.

Der DC/Puls-Wandler 1 kann mit jeder Art von Forward-Topologie und synchroner Gleichrichtung realisiert werden. Eine synchrone Gleichrichtung ist notwendig für eine Rückspeisung elektrischer Energie zur Eingangsspannung Vᵢₙ, denn innerhalb der Schaltung findet kein Energieverbrauch mehr statt, wie dies bei bekannten Linearverstärkern der Fall ist.

Die Darstellung in FIG 4 zeigt den Linientreiber 2a aus FIG 3 und den darin integrierten DC/Puls-Wandler 1 mit weiteren Einzelheiten. Genau wie bei der in FIG 2 gezeigten Ausführungsform umfasst auch der Linientreiber 2a gemäß FIG 4 zwei D/A-Wandler 21, 21a zur Vorgabe von Grenzwerten (voltage set, current set) für die Ausgangsspannung und den Ausgangsstrom.

Von dem aufgrund des vorgegebenen Spannungsgrenzwerts (voltage set) resultierenden Wert am Ausgang des ersten D/A-Wandlers 21 wird - genau wie bei der Ausführungsform gemäß FIG 2 - die über einen Rückführzweig 20 mit inverser Systemverstärkung (1/G) zurückgeführte Ausgangsspannung Vₒᵤₜ₊ abgezogen und das resultierende Signal (erstes Fehlersignal) einem ersten Regler 22 zugeführt. Ähnlich wird - ebenfalls genau wie bei der Ausführungsform gemäß FIG 2 - von dem aufgrund des vorgegebenen Stromgrenzwerts (current set) resultierenden Wert am Ausgang des zweiten D/A-Wandlers 21 der über einen Rückführzweig 26 zurückgeführte jeweilige Ausgangsstrom abgezogen und das resultierende Signal (zweites Fehlersignal) einem zweiten Regler 22a zugeführt. Eines der Ausgangssignale der beiden Regler 22, 22a wird - abhängig von einer Verarbeitung durch einen Prioritätsblock 23 wie bei der Ausführungsform gemäß FIG 2 - einem Pulsweitenmodulator 24 zugeführt. Bei der gezeigten Ausführungsform fungiert ein Komparator als Pulsweitenmodulator 24 und dieser erzeugt ein PWM-Signal auf Basis eines Vergleichs des vom Prioritätsblock 23 weitergeleiteten Fehlersignals mit einem Dreiecksignal. Das Dreiecksignal wird mittels eines Dreiecksignalgenerators 28 auf Basis eines von einem Taktgenerator 29 generierten Taktsignals generiert.

Die Weiterleitung des PWM-Signals erfolgt entsprechend der jeweiligen Schalttopologie des Wandlers 1 und dessen erster und zweiter Schaltstufe 11, 13. Als Schalttopologie wird dabei der Aufbau des Transformators 12 zusammen mit von dem Wandler 1 umfassten Schaltern 27a, 27b, 131a, 131b verstanden. Ein DC/Puls-Wandler 1 kann mit verschiedenen Ansteuerungen und verschiedener Transformatoraufbauten realisiert werden. Die Anzahl der verwendeten Schalter 27a, 27b, 131a, 131b und die Art, wie aus dem PWM-Signal die Ansteuerung dieser Schalter 27a, 27b, 131a, 131b generiert wird, kann variieren und ist hauptsächlich abhängig von der Ausgangsleistung. Bei der Ausführungsform gemäß FIG 4 umfasst die erste Schaltstufe 11 eine erste Leistungsstufe 111 und die zweite Schaltstufe 13 eine zweite Leistungsstufe 131 und die Weiterleitung des PWM-Signals erfolgt mittels eines Logikblocks 27. Die Leistungsstufen 111, 131 sind als Halbbrücken-Durchflusswandler mit synchroner Gleichrichtung (half bridge forward converter with synchronous rectification) ausgeführt.

Das PWM-Signal wird mittels des Blocks 24 durch den Vergleich des Fehlersignals (Ausgang von Block 23) mit dem vom Dreiecksignalgenerator 28 stammenden Dreieckssignal erzeugt. Der Logikblock 27 entschlüsselt das PWM-Signal zur Generierung der topologiespezifischen Schaltmuster für die einzelnen Schalter 27a, 27b, 131a und 131b. Vom Logikblock 27 wird das Ansteuersignal für die Schalter 27a, 27b mittels zweier Treiber 27c, 27d galvanisch isoliert in den Wandler 1 eingespeist und zwar zunächst in dessen erste Leistungsstufe 111. Hier wird die Eingangsspannung entsprechend dem aus dem PWM-Signal entschlüsselten Schaltmuster zerhackt und gelangt zur Primärwicklung des Transformators 12. Das Windungsverhältnis des Transformators 12 ist so ausgelegt, dass je nach Puls-/Pausenverhältnis des PWM-Signals die Spannung am Ausgang auf den gewünschten Wert eingestellt werden kann, welcher von der Zentrale am Eingang voltage set vorgegeben und durch den Regelkreis 20, 21, 22 mit dem ersten Regler 22 (erster Regelkreis 20, 21, 22) mit der Systemverstärkung G verstärkt wird. Der Regelkreis 26, 21a, 22a mit dem zweiten Regler 22a (zweiter Regelkreis 26, 21a, 22a) reduziert über den Prioritätsblock 23 die Ausgangsspannung Vₒᵤₜ, wenn der Ausgangsstrom den an current set eingestellten Wert zu überschreiten droht. Mittels des Transformators 12 erfolgt die galvanisch isolierte Übertragung zur zweiten Leistungsstufe 131. Hier wird das zerhackte Signal mittels der beiden von der zweiten Leistungsstufe 131 umfassten elektronischen Schalter 131a, 131b, insbesondere elektronischer Schalter in Form von MOSFETs, gleichgerichtet und zusammengesetzt. Die beiden elektronischen Schalter 131a, 131b erlauben (im Unterschied zu dem DC/DC-Wandler 1 in FIG 1, wo dies nicht nötig ist) eine Energieübertragung von Vᵢₙ zu Vₒᵤₜ oder alternativ von Vₒᵤₜ zu Vᵢₙ, für den Fall, dass die Kapazität der Übertragungsleitung während einer negativen Flanke entladen werden muss. Das nach dem Zerhacken (erste Leistungsstufe 111) gleichgerichtete (zweite Leistungsstufe 131) Signal wird mittels eines Filters 132 (Ausgangsfilter), insbesondere eines als Tiefpassfilter fungierenden Filters 132 in Form eines LC-Glieds, gefiltert und am Ausgang des Wandlers 1 und damit am Ausgangs des Leitungsverstärkers insgesamt ergibt sich als Ausgangsspannung Vₒᵤₜ eine gepulste Spannung zur elektrischen Versorgung der Feldgeräte 4.

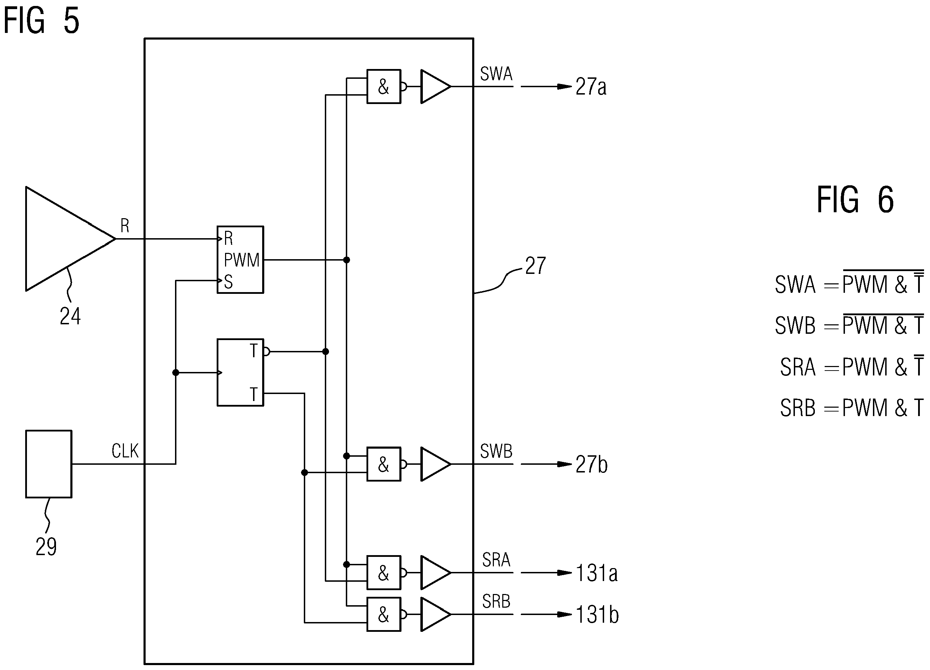

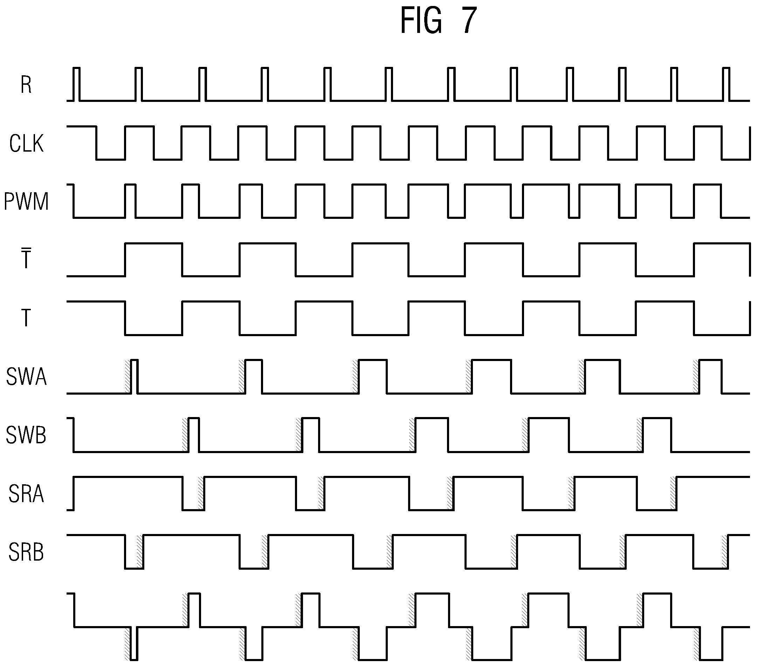

Die Darstellung in FIG 5 zeigt die Funktion des Logikblocks 27. Der Ausgang des Pulsweitenmodulators 24 geht im Logikblock 27 auf den rücksetzenden Eingang eines RS-Glieds (an den setzenden Eingang ist der Taktgenerator 29 angeschlossen) und der Ausgang des RS-Glieds wird als PWM-Signal (PWM) mittels nachfolgender UND-Gatter zur Erzeugung von Ansteuersignalen SWA, SWB zur Ansteuerung der Treiber 27c, 27d und der nachfolgenden Schalter 27a, 27b der ersten Leistungsstufe 111 sowie zur Erzeugung von Ansteuersignalen SRA, SRB zur Ansteuerung der elektronischen Schalter 131a, 131b der zweiten Leistungsstufe 131 weiterverarbeitet. FIG 6 zeigt das Impulsdiagramm für die Funktionalität des Logikblocks 27 und FIG 7 zeigt einen Verlauf einzelner wesentlicher Signale über der Zeit, wobei das in FIG 7 ganz unten gezeigte Signal die Spannung über der Primärwicklung (auf der Seite der ersten Leistungsstufe 111) des Transformators 12 darstellt.

Im Vergleich zu der Schaltung gemäß der eingangs genannten, älteren, nicht vorveröffentlichten europäischen Patentanmeldung mit dem Titel "Verstärkerschaltung und Verfahren zum Betrieb einer Verstärkerschaltung" (Anmeldetag: 01.06.2015) ergibt sich eine Schaltung, die einen Verzicht auf eine der in der älteren Anmeldung gezeigten Halbbrücken (dort in der Darstellung in FIG 4 mit den Bezugsziffern 60, 62 bezeichnet) ermöglicht. Die oben genannte ältere Anmeldung umfasst wesentliche Erläuterungen zu einzelnen grundsätzlichen Funktionen der Schaltungsteile der in dieser Anmeldung vorgeschlagenen Verstärkerschaltung und soll demgemäß mit diesem Hinweis in vollem Umfang als in die hier vorgelegte Beschreibung einbezogen gelten.

Obwohl die Erfindung im Detail durch das Ausführungsbeispiel näher illustriert und beschrieben wurde, so ist die Erfindung nicht durch das oder die offenbarten Beispiele eingeschränkt und andere Variationen können vom Fachmann hieraus abgeleitet werden, ohne den Schutzumfang der Erfindung zu verlassen. Einzelne im Vordergrund stehende Aspekte der hier eingereichten Beschreibung lassen sich damit kurz wie folgt zusammenfassen: Angegeben werden eine als Linientreiber fungierende Verstärkerschaltung und ein Verfahren zum Betrieb einer Verstärkerschaltung, wobei die Besonderheit darin besteht, dass ein DC/DC-Wandler als Leistungsstufe in die Verstärkerschaltung integriert ist.

### Bezugszeichenliste

- 1: DC/DC-Wandler, Wandler, DC/Puls-Wandler
- 2: Linearverstärker
- 2a: Verstärkerschaltung
- 3: Multiplexerschaltung
- 4: Feldgerät
- 11: erste Schaltstufe
- 12: Transformator
- 13: zweite Schaltstufe
- 14: Optokoppler
- 20: Rückführzweig
- 21: D/A-Wandler
- 21a: D/A-Wandler
- 22: Regler
- 22a: Regler
- 23: Prioritätsblock
- 24: Vorverstärker / Pulsweitenmodulator
- 25: Leistungsstufe
- 26: Rückführzweig
- 27: Logikblock
- 27a, b: Schalter
- 27c, d: Treiber
- 28: Dreiecksignalgenerator
- 29: Taktgenerator
- 110: Pulsweitenmodulator
- 111: erste Leistungsstufe
- 131: zweite Leistungsstufe
- 131a, b: elektronischer Schalter
- 132: Filter
- 133: Rückführzweig

## Patentansprüche

1. Verstärkerschaltung (2a) mit einem als Leistungsstufe in die Verstärkerschaltung (2a) integrierten DC/DC-Wandler (1),
- wobei die Verstärkerschaltung (2a) als Linientreiber in einer Übertragungsleitung zwischen einer Zentrale und an die Übertragungsleitung angeschlossenen Feldgeräten (4) fungiert,
- wobei der integrierte DC/DC-Wandler (1) als DC/Puls-Wandler (1) fungiert,
- wobei der DC/Puls-Wandler (1) zwei galvanisch getrennte und mittels eines Transformators (12) induktiv gekoppelte Schaltstufen (11, 13) umfasst,
- wobei dem DC/Puls-Wandler (1) ein Logikblock (27) vorgeschaltet ist, und
- wobei mittels des Logikblocks (27) aus einem PWM-Signal Ansteuersignale für Schalter (27a, 27b) des DC/Puls-Wandlers (1) generierbar und mittels Treibern (27c, 27d) galvanisch isoliert in den DC/Puls-Wandler (1) einspeisbar sind,
- wobei die Verstärkerschaltung (2a) einen Prioritätsblock (23) sowie einen ersten Regler (22) und einen zweiten Regler (22a) umfasst,
- wobei das PWM-Signal anhand eines Ausgangs des Prioritätsblocks (23) generierbar ist,
- wobei mittels des Prioritätsblocks (23) entweder ein Ausgangssignal des ersten Reglers (22) oder ein Ausgangssignal des zweiten Reglers (22a) weiterleitbar ist,
- wobei mittels des ersten Reglers (22) ein erstes Fehlersignal auf Basis eines vorgegebenen oder vorgebbaren Spannungsgrenzwerts sowie einer innerhalb der Verstärkerschaltung (2a) über einen Rückführzweig (20) zurückgeführten Ausgangsspannung generierbar ist,
- wobei mittels des zweiten Reglers (22a) ein zweites Fehlersignal auf Basis eines vorgegebenen oder vorgebbaren Stromgrenzwerts sowie eines innerhalb der Verstärkerschaltung (2a) über einen Rückführzweig (26) zurückgeführten Ausgangsstroms generierbar ist, wobei an einem ersten Eingang (current set) und einem zweiten Eingang (voltage set) der Stromgrenzwert bzw. der Spannungsgrenzwert durch die Zentrale vorgebbar sind,
- wobei die erste Schaltstufe (11) und die zweite Schaltstufe (13) jeweils eine Leistungsstufe (111, 113) - erste Leistungsstufe (111), zweite Leistungsstufe (113) - umfassen,
- wobei mittels der ersten Leistungsstufe (111) aus einer der ersten Leistungsstufe (111) zugeführten Eingangsspannung (Vᵢₙ) eine über den Transformator (12) übertragbare, entsprechend einem mittels der Verstärkerschaltung (2a) generierbaren PWM-Signal zerhackte Spannung generierbar ist,
- wobei mittels der zweiten Leistungsstufe (113) die mittels des Transformators (12) übertragene zerhackte Spannung phasenrichtig zusammensetzbar ist, und
- wobei die Leistungsstufen (111, 113) als Halbbrücken-Durchflusswandler mit synchroner Gleichrichtung ausgeführt sind.

2. Verstärkerschaltung (2a) nach Anspruch 1,
- wobei die erste Leistungsstufe (111) zwei Schalter (27a, 27b) und die zweite Leistungsstufe (113) zwei Schalter (131a, 131b) umfasst und
- wobei Ansteuersignale für die Schalter (27a, 27b, 131a, 131b) mittels eines Logikblocks (27) aus einem PWM-Signal generierbar sind.

3. Verfahren zum Betrieb einer Verstärkerschaltung (2a) nach Anspruch 1 oder 2,
- wobei mittels des Logikblocks (27) aus einem PWM-Signal Ansteuersignale für Schalter (27a, 27b) des DC/Puls-Wandlers (1) generiert und mittels Treibern (27c, 27d) galvanisch isoliert in den DC/Puls-Wandler (1) eingespeist werden,
- wobei das PWM-Signal anhand eines Ausgangs eines von der Verstärkerschaltung (2a) umfassten Prioritätsblocks (23) generiert wird,
- wobei mittels des Prioritätsblocks (23) ein Ausgangssignal eines ersten oder eines zweiten von der Verstärkerschaltung (2a) umfassten Reglers (22, 22a) weitergeleitet wird,
- wobei mittels des ersten Reglers (22) ein erstes Fehlersignal auf Basis eines vorgegebenen Spannungsgrenzwerts sowie einer innerhalb der Verstärkerschaltung (2a) über einen Rückführzweig (20) zurückgeführten Ausgangsspannung generiert wird,
- wobei mittels des zweiten Reglers (22a) ein zweites Fehlersignal auf Basis eines vorgegebenen Stromgrenzwerts sowie eines innerhalb der Verstärkerschaltung (2a) über einen Rückführzweig (26) zurückgeführten Ausgangsstroms generiert wird,
- wobei der integrierte DC/DC-Wandler (1) als DC/Puls-Wandler (1) fungiert und zwei galvanisch getrennte sowie mittels eines Transformators (12) induktive gekoppelte Schaltstufen (11, 13) umfasst,
- wobei die erste Schaltstufe (11) und die zweite Schaltstufe (13) jeweils eine Leistungsstufe (111, 113) - erste Leistungsstufe (111), zweite Leistungsstufe (113) - umfassen,
- wobei mittels der ersten Leistungsstufe (111) aus einer der ersten Leistungsstufe (111) zugeführten Eingangsspannung (Vᵢₙ) eine über den Transformator (12) übertragbare, entsprechend einem mittels der Verstärkerschaltung (2a) generierbaren PWM-Signal zerhackte Spannung generiert wird,
- wobei mittels der zweiten Leistungsstufe (113) die mittels des Transformators (12) übertragene zerhackte Spannung phasenrichtig zusammengesetzt wird, und
- wobei die Leistungsstufen (111, 113) als Halbbrücken-Durchflusswandler mit synchroner Gleichrichtung ausgeführt werden, um insbesondere elektrische Energie zur Eingangsspannung (Vᵢₙ) zurückzuspeisen.

4. Verfahren nach Anspruch 3,
- wobei die erste Leistungsstufe (111) zwei Schalter (27a, 27b) und die zweite Leistungsstufe (113) zwei Schalter (131a, 131b) umfasst und
- wobei Ansteuersignale für die Schalter (27a, 27b, 131a, 131b) mittels eines Logikblocks (27) aus einem PWM-Signal generiert werden.

5. Vorrichtung zum Ansteuern von als Alarmierungs-Einrichtungen fungierenden Feldgeräten (4) mit einer Verstärkerschaltung (2a) nach einem der Ansprüche 1 bis 2.
